# EUROPEAN PATENT APPLICATION

(11) **EP 3 349 356 A1**
(43) Date of publication of application: **18.07.2018**
(21) Application number: 17208825.4
(22) Date of filing: 20.12.2017
(51) Int. Cl.: H03G 3/00, H03G 3/30, H04M 1/60, H04M 9/08

(54) **ELECTRONIC DEVICE AND CONTROL PROGRAM OF ELECTRONIC DEVICE**

(30) Priority: 17.01.2017 JP 2017005656
(71) Applicant: Onkyo Corporation, Osaka 572-0028 (JP)
(72) Inventor: KONDO, Yusuke, Neyagawa-shi, Osaka 572-0028 (JP)
(74) Representative: Horn Kleimann Waitzhofer Patentanwälte PartG mbB

(57) **Abstract**

Problem: To be able to observe regulation in audio output by telephone function.

Solution: A mobile phone 1 includes a DAC 7 that has volume adjustment function and converts digital audio data into analog audio data and an SoC 2. The SoC 2 performs volume control for sound pressure regulation by the DAC 7 except during call. Further, the SoC 2 releases volume control for sound pressure regulation by the DAC 7 and performs control for regulation in audio output by telephone function during call.

## Description

### TECHNICAL FIELD

The present invention relates to an electronic device that has telephone function and a control program of the electronic device.

### BACKGROUND ART

An applicant applies JP 2015-171796. Fig. 3 is a diagram illustrating flow of audio data in a digital audio player (hereinafter, referred as to "DAP") of an invention according to JP 2015-171946. The DAP mounts Android (registered trademark) OS. An SoC (System on Chip) performs music reproducing according to Audio Framework (framework) that is produced by Android (registered trademark) basically when reproducing music. First, digital audio data is output from an application to framework. Framework includes Audio system (Audio system) and Mixer (Mixer). Audio system is a module that performs setting related to input/output of digital audio data. Mixer is a module that combines a plurality of tracks and applies attenuation of volume and effects. SoC performs processing according to the audio system and the mixer.

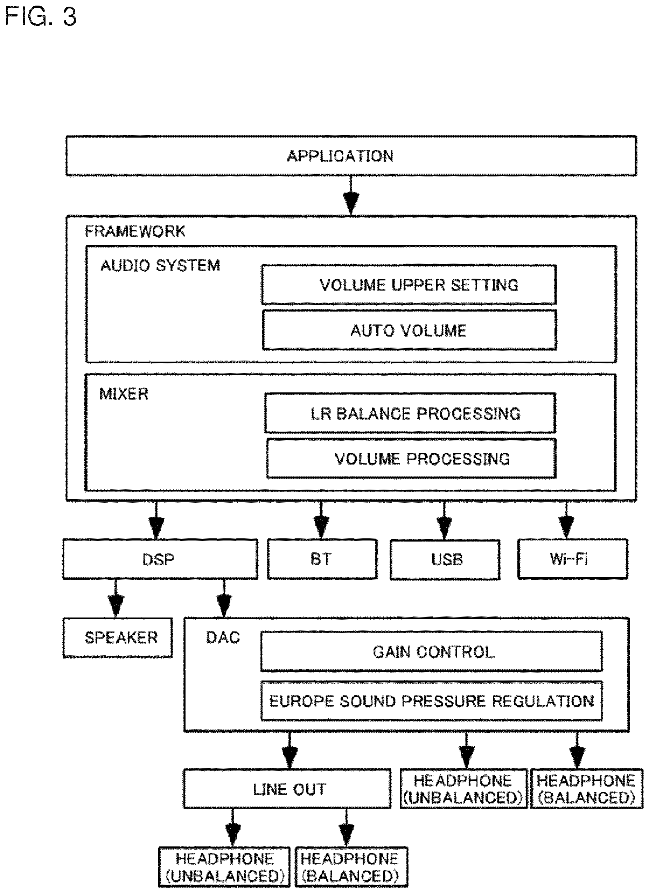

Digital audio data is output to a DSP, a wireless module ("BT" and "Wi-Fi" in Fig. 3), and a USB I/F. In Fig. 3, digital audio data is output to an external device according to Bluetooth (registered trademark) standard in "BT". Digital audio data is output to an external device according to USB standard (USB audio class) in "USB". Digital audio data is output to an external device according to Wi-Fi standard in "Wi-Fi".

The DSP decodes digital audio data so as to output to a speaker and a DAC (D/A converter). The DAC D/A-converts digital audio data into analog audio data so as to output analog audio data to a line out output terminal (line out), an unbalanced output terminal (headphone (unbalanced)), and a balanced output terminal (headphone (balanced)). The DAC has volume adjustment function. (See patent literature 1 about balanced output and unbalanced output).

In the invention according to JP 2015-171796, volume control that relates to only the headphone is performed by the DAC that has volume adjustment function nearest from the headphone output. Further, volume control except volume control that relates to only the headphone is performed by the SoC. For example, volume control that relates to only the headphone is Europe sound pressure regulation that limits upper of volume to sound pressure level that is defined by Europe sound pressure regulation (EN50332). The SoC can perform volume control for Europe sound pressure. However, volume control for Europe sound pressure is performed by the DAC because the SoC performs volume control to output of BT, USB, and Wi-Fi.

Herein, it is thought that telephone function is added to the invention according to JP 2015-171796. When a headset that has a headphone and a microphone is connected to a device, in audio output by telephone function, regulation is defined by 3GPP and it is necessary to observe it. In regulation of 3GPP, regulation of not only sound pressure but also distortion ratio and frequency characteristics are included. To meet regulation of 3GPP, sound pressure regulation of the DAC is insufficient. Herein, "telephone function" includes telephone function by 3G/LTE (4G) circuit, telephone function by VOIP, and telephone function by SNS application such as Facebook (registered trademark).

### PRIOR ART DOCUMENT

### PATENT LITERATURE

PATENT LITERATURE 1: JP 2013-005291 A

### SUMMARY OF THE INVENTION

### PROBLEM TO BE RESOLVED BY THE INVENTION

As described above, in audio output by telephone function, there is a problem that sound pressure of the DAC is insufficient. 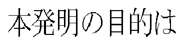 , 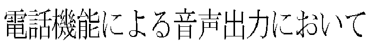 , 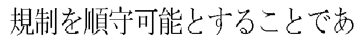 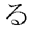 .

An objective of the present invention is to be able to observe regulation in audio output by telephone function.

### MEANS FOR SOLVING THE PROBLEM

An electronic device of a first invention configured to have telephone function comprising: a D/A converter configured to have volume control function and configured to D/A convert a digital audio signal into an analog audio signal; and a controller configured to perform volume control for sound pressure regulation by the D/A converter except during call, release volume control for sound pressure regulation by the D/A converter during call, and perform control for regulation in audio output by telephone function during call.

In the present invention, a controller is configured to perform volume control for sound pressure regulation by a D/A converter except during call. Thus, sound pressure regulation can be observed. Further, the controller is configured to release volume control for sound pressure regulation by the D/A converter and to perform control for regulation in audio output by telephone function during call. For example, regulation of audio output by telephone function is regulation by regulation of 3GPP and includes sound pressure, distortion ration, and frequency characteristics. Regulation can be observed in audio output (during call) by telephone function because the controller can control them.

The electronic device of a second invention is the electronic device of the first invention, wherein the controller is configured to adjust volume during call when it receives operation for volume adjustment.

The electronic device of a third invention is the electronic device of the first or the second invention, wherein the D/A converter is configured to perform volume control for sound pressure regulation by limiting upper of volume to a predetermined sound pressure level.

The electronic device of a fourth invention is the electronic device of any one of the first to the third inventions configured to have an unbalanced mode configured to amplify a non-inverted audio signal and output the amplified non-inverted audio signal by one amplifier, a balanced mode configured to amplify a non-inverted audio signal by one amplifier, amplify an inverted audio signal by the other amplifier, mix the amplified non-inverted audio signal and the amplified inverted audio signal and output the mixed audio signal, and an active control ground mode configured to amplify a non-inverted audio signal by one amplifier and maintain ground by the other amplifier, wherein the controller is configured to change volume settings based on modes during call.

A control program of an electronic device of a fifth invention configured to have telephone function and comprise a D/A converter configured to have volume adjustment function and convert a digital audio signal into an analog audio signal and a controller, the control program is configured to cause the controller to perform volume control for sound pressure regulation by the D/A converter except during call, to release volume control for sound pressure regulation by the D/A converter during call, and to perform control for regulation in audio output by telephone function during call.

### EFFECT OF THE INVENTION

According to the present invention, regulation of audio output by telephone function can be observed.

### BRIEF DESCRIPTION OF THE DRAWINGS

Fig. 1 is a block diagram illustrating a configuration of a mobile phone according to an embodiment of the present invention.
Fig. 2 is a sequence diagram illustrating processing operation of the mobile phone when a call arrives.
Fig. 3 is a diagram illustrating flow of audio data in a digital audio player of an invention according to JP 2015-171796.

### DESCRIPTION OF THE EMBODIMENTS

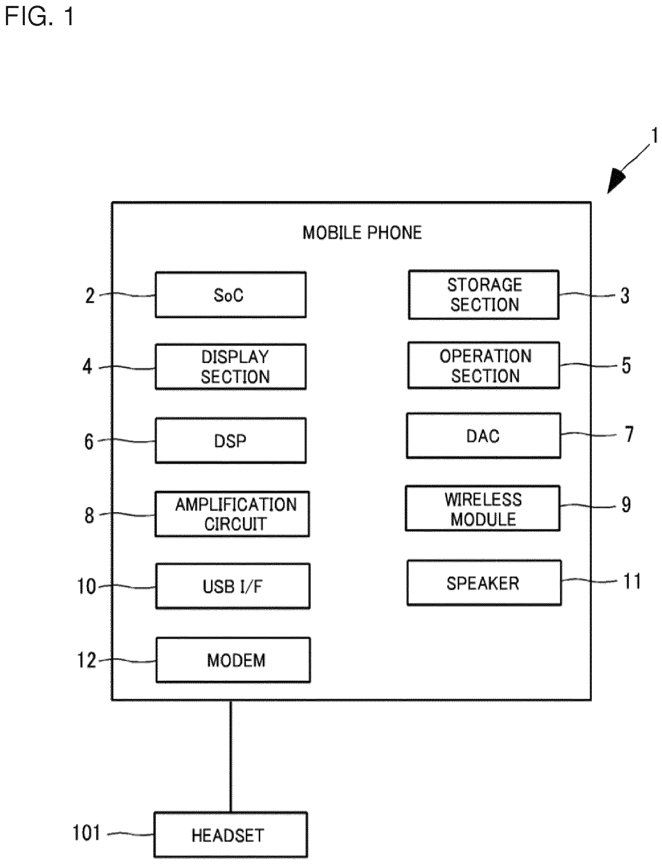

An embodiment of the present invention is described below. Fig. 1 is a block diagram illustrating a configuration of a mobile phone according to an embodiment of the present invention. The mobile phone 1 (electronic device) includes an SoC 2, a storage section 3, a display section 4, an operation section 5, a DSP 6, a D/A converter (hereinafter, referred as to "DAC") 7, an amplification circuit 8, a wireless module 9, a USB interface (hereinafter, referred as to "USB I/F") 10, a speaker 11, and a modem 12. The mobile phone 1 according to the present embodiment is a so-called smart phone.

The SoC (System on Chip) 2 (controller) has a CPU (Central Processing Unit), a DSP (Digital Signal Processor), a memory and so on, and controls respective sections composing the mobile phone 1. The storage section 3 is a flash memory that stores programs such as an OS program and application programs and various data such as digital audio data. The storage section 3 is not limited to the illustrated configuration, and may be an HDD (Hard Disk Drive).

The display section 4 displays various images (including still images and moving images), and is composed of a liquid crystal panel. The operation section 5 has operation keys for performing various settings, and a touch panel that is linked with the display section 4. A user can input various characters and perform setting via the operation section 5.

The DSP (Digital Signal Processor) 6 performs signal processing such as equalizer processing and decode to digital audio data. The DAC 7 (D/A converter) D/A-converts the digital audio data (digital audio signal) into analog audio data (analog audio signal). Further, the DAC 7 has volume adjustment function. The amplification circuit 8 amplifies the analog audio data that the DAC 7 D/A-converts and outputs the amplified analog audio data to a headset 101 or a headphone. The wireless module 9 is for performing wireless communication according to Bluetooth (registered trademark) standard and Wi-Fi standard. The USB I/F 10 is for performing communication according to USB standard.

The modem 12 is for performing call with the other device and performs modulation and demodulation of sending and receiving data.

The SoC 2 performs music reproduction according to Audio Framework (framework) that is produced by Android (registered trademark) basically like an invention according to JP 2015-171796 when reproducing music (see Fig. 3).

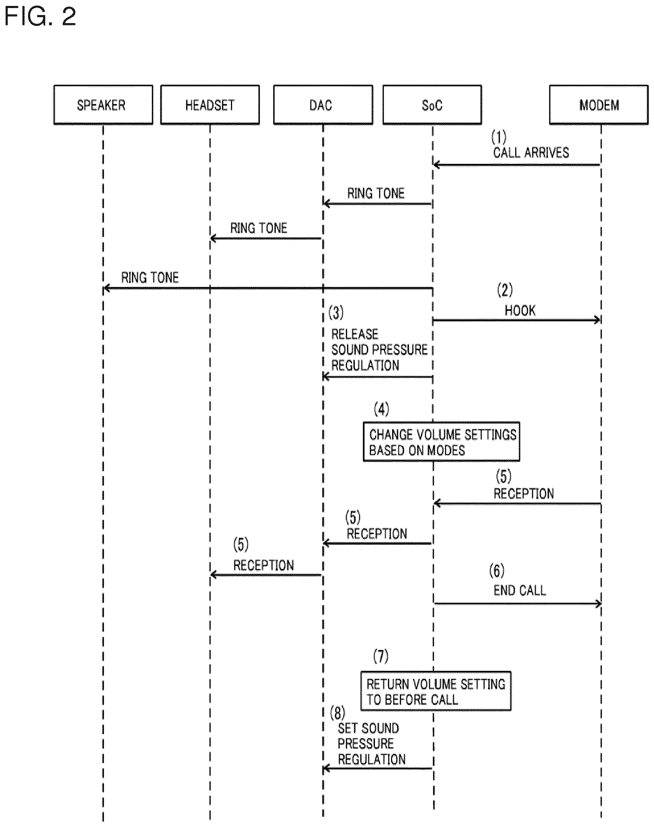

Fig. 2 is a sequence diagram illustrating processing operation of the mobile phone 1 when a call arrives. The mobile phone 1 performs the following processing when the headset 101 that has a headphone and a microphone or the headphone is connected to the mobile phone 1. In the mobile phone 1, after a call occurs (1), when the SoC 2 receives a predetermined operation via the operation section 5, it receives the call (hook) (2). Next, the SoC 2 releases volume control for sound pressure regulation by the DAC 7 (3). At the same time, the SoC 2 performs control for regulation in audio output by telephone function. The SoC 2 performs control for regulation in audio output by telephone function by tuning distortion ratio of speech voice, frequency characteristics, and sound pressure.

Further, the SoC 2 changes volume settings based on modes (4). Herein, modes include an unbalanced mode, a balanced mode, and an active control ground (hereinafter, referred as "ACG") mode. The unbalanced mode is a mode that amplifies non-inverted analog audio data by one amplifier included in the amplification circuit 8 and outputs amplified analog audio data. The balanced mode is a mode that amplifies non-inverted analog audio data by one amplifier included in the amplification circuit 8, amplifies inverted analog audio data by the other amplifier included in the amplification circuit 8, mixes the amplified non-inverted analog audio data and the amplified inverted analog audio data and outputs the mixed analog audio data. The ACG mode is a mode that amplifies non-inverted analog audio data by one amplifier included in the amplification circuit 8 and maintains ground by the other amplifier included in the amplification circuit 8. The SoC 2 maintains ground by the other amplifier by muting output of the DAC 7 that outputs digital audio data to the other amplifier. It is necessary to separate settings because output sound pressure is different in each of modes.

The SoC 2 starts the call by D/A-converting a received an audio signal by the DAC 7 and outputting the D/A-converted audio signal from the headset 101 (or the headphone) (reception) (5). When the SoC 2 receives predetermined operation, it ends the call (6). Next, the SoC 2 returns volume setting to before the call (7). Next, the SoC 2 performs volume control for sound pressure regulation by the DAC 7 (8). The DAC 7 performs the volume control for the sound pressure regulation by limiting upper of volume to sound pressure level that is defined by sound pressure regulation (EN50332).

When the SoC 2 receives operation for volume adjustment via the operation section 5 during call, it adjusts volume. Further, when the SoC 2 receives operation for setting change of the DAC 7 via the operation section 5 during call, it changes setting of the DAC 7.

As described above, the SoC 2 performs volume control for sound pressure regulation by the DAC 7 except during call (for example, when reproducing music). Thus, sound pressure regulation can be observed. Further, the SoC 2 releases volume control for sound pressure regulation by the DAC 7 during call and performs control for regulation in audio output by telephone function during call. For example, regulation during call is regulation by regulation of 3GPP and includes sound pressure, distortion ration, and frequency characteristics. Regulation can be observed in audio output by telephone function because the SoC 2 can control them.

The embodiment of the present invention is described above, but the mode to which the present invention is applicable is not limited to the above embodiment and can be suitably varied without departing from the scope of the present invention.

In the above described embodiment, a mobile phone (smart phone) that performs telephone function by 3G / LTE (4G) circuit is illustrated as an electronic device. Not limited to this, an electronic device may be a tablet PC, a digital audio player (DAP), or the like. In this case, telephone function may be performed by SNS application. Further, telephone function may be performed by VOIP circuit.

### INDUSTRIAL APPICABILITY

The present invention can be suitably employed in an electronic device that has telephone function and a control program of the electronic device.

### DESCRIPTION OF REFFERENCE SIGNS

- 1: mobile phone (electronic device)
- 2: SoC (controller)
- 4: display section
- 5: operation section
- 7: DAC (D/A converter)
- 8: amplification circuit
- 12: modem

## Claims

1. An electronic device configured to have telephone function comprising:
a D/A converter configured to have volume control function and configured to D/A convert a digital audio signal into an analog audio signal; and
a controller configured to
perform volume control for sound pressure regulation by the D/A converter except during call,
release volume control for sound pressure regulation by the D/A converter during call,
and perform control for regulation in audio output by telephone function during call.

2. The electronic device according to claim 1, wherein the controller is configured to adjust volume during call when it receives operation for volume adjustment.

3. The electronic device according to claim 1 or 2, wherein the D/A converter is configured to perform volume control for sound pressure regulation by limiting upper of volume to a predetermined sound pressure level.

4. The electronic device according to any one of claims 1 to 3 configured to have
an unbalanced mode configured to amplify a non-inverted audio signal and output the amplified non-inverted audio signal by one amplifier,
a balanced mode configured to amplify a non-inverted audio signal by one amplifier, amplify an inverted audio signal by the other amplifier, mix the amplified non-inverted audio signal and the amplified inverted audio signal and output the mixed audio signal, and
an active control ground mode configured to amplify a non-inverted audio signal by one amplifier and maintain ground by the other amplifier,
wherein the controller is configured to change volume settings based on modes during call.

5. A control program of an electronic device configured to have telephone function and comprise a D/A converter configured to have volume adjustment function and convert a digital audio signal into an analog audio signal and a controller,
the control program is configured to cause the controller
to perform volume control for sound pressure regulation by the D/A converter except during call,
to release volume control for sound pressure regulation by the D/A converter during call,
and to perform control for regulation in audio output by telephone function during call.
